(19) Europäisches Patentamt
European Patent Office
Office européen des brevets

(11) **EP 3 890 192 B1**

(12) **FASCICULE DE BREVET EUROPEEN**

(45) Date de publication et mention de la délivrance du brevet:
**26.04.2023 Bulletin 2023/17**

(21) Numéro de dépôt: **21163990.1**

(22) Date de dépôt: **22.03.2021**

(51) Classification Internationale des Brevets (IPC):
***H03M 13/09*** *(2006.01)*

(52) Classification Coopérative des Brevets (CPC):
**H03M 13/091**

(54) **CIRCUIT DE CALCUL DE CRC RAPIDE UTILISANT UN POLYNÔME RÉDUCTEUR RECONFIGURABLE AU VOL**

SCHNELLE CRC-BERECHNUNGSSCHALTUNG, DIE EIN REDUZIERENDES POLYNOM VERWENDET, DAS IM FLUG REKONFIGURIERBAR IST

QUICK CRC CALCULATION CIRCUIT USING A REDUCTOR POLYNOMIAL RECONFIGURABLE ON THE FLIGHT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.03.2020 FR 2003134**

(43) Date de publication de la demande:
**06.10.2021 Bulletin 2021/40**

(73) Titulaire: **Kalray**
**38330 Montbonnot Saint Martin (FR)**

(72) Inventeur: **BRUNIE, Nicolas**
**38000 GRENOBLE (FR)**

(74) Mandataire: **de Jong, Jean Jacques et al**
**Omnipat**
**24, place des Martyrs de la Résistance**
**13100 Aix en Provence (FR)**

(56) Documents cités:
**US-A1- 2006 282 743    US-A1- 2009 157 784**

- **DAVID C FELDMEIER: "Fast software implementation of error detection codes", IEEE /ACM TRANSACTIONS ON NETWORKING, IEEE / ACM, NEW YORK, NY, US, vol. 3, no. 6, décembre 1995 (1995-12), pages 640-651, XP058214351, ISSN: 1063-6692, DOI: 10.1109/90.477710**

## Description

### Domaine technique

L'invention est relative au calcul au vol de signatures ou codes de redondance cyclique (CRC) sur un flux de données.

### Arrière-plan technique

Les codes CRC sont utilisés notamment pour vérifier l'intégrité des données transmises sur un lien de communication, en comparant le code calculé à la destination avec un code qui a été inséré dans le flux à la source.

De façon générale, un code CRC calculé sur un message binaire est le reste de la division dans un corps de Galois de caractéristique 2 GF($2^N$) d'un polynôme représentant le message par le polynôme réducteur du corps de Galois. Plus spécifiquement, le code CRC est exprimé sous forme polynomiale par :

$$\mathrm{CRC}(\{m\}) = \{m\} \bullet X^N \ mod \ P,$$

Où {m} est le message binaire représenté sous forme polynomiale, P le polynôme réducteur, et N le degré du polynôme réducteur.

Ci-après, on utilise la notation « {x} » pour désigner un élément du corps de Galois ou le polynôme représentant la valeur binaire de x, où x sera parfois exprimé par une valeur scalaire. Par exemple, {5} est l'élément du corps de Galois correspondant à la valeur binaire « 101 » ou au polynôme $X^2+1$.

Les liens de communication peuvent être utilisés aujourd'hui pour transmettre en série de multiples flux imbriqués selon différentes normes. Les différentes normes peuvent utiliser des codes CRC ayant des polynômes réducteurs différents. Ainsi, l'équipement de réception des flux doit être capable de traiter ces données arrivant à haut débit en appliquant un polynôme réducteur adapté.

Le calcul d'un code CRC peut être complexe si les tailles du message et du code sont grandes. Pour obtenir un compromis entre complexité et rapidité de calcul, des opérateurs matériels dédiés reposent sur un découpage du message en chiffres de petite taille, et qui opèrent sur les chiffres individuels en utilisant des tables peuplées en fonction du polynôme réducteur. Les tables peuvent contenir des résultats de calcul partiels ou directement des valeurs de CRC. Les codes calculés sur les chiffres sont ensuite combinés en utilisant des propriétés de récursivité pour calculer le code sur l'ensemble du message. Un tel opérateur est décrit, par exemple, dans le brevet US6223320. Il est également fait référence aux documents suivants: US 2009/15778A1, Gopal Vinodh et al, 18 juin 2009; US 2006/282743 A1, Kouvanis Michael, 14 décembre 2006; et David Feldmeier: "Fast software implementation of error détection codes", IEEE/ACM Transactions on Networking, NY, US, vol. 3, no. 6, décembre 1995, pages 640-651, XP058214351. Ces trois documents divulguent des méthodes de génération de CRC basées sur une sélection des bits de poids faible d'un produit par le polynôme réducteur P d'un quotient d'une division par P , ce dernier étant obtenu par multiplication par le polynôme réciproque de P.

### Résumé de l'invention

On prévoit de façon générale un circuit de génération d'un code de redondance cyclique (CRC) de N bits sur un chiffre d de k bits selon la revendication 1. Des modes de réalisations préférentiels sont définis dans les revendications 2 à 7.

### Présentation des figures

Des modes de réalisation seront exposés dans la description suivante, faite à titre non limitatif en relation avec les figures jointes parmi lesquelles :

La figure 1 illustre un schéma-bloc d'un mode de réalisation d'opérateur de calcul de CRC utilisant une table dynamique reconfigurable en fonction du polynôme réducteur ;
La figure 2 illustre un schéma-bloc d'un exemple de réalisation d'une sous-table de multiplication incorporée dans la table dynamique de la figure 1 ;
La figure 3A illustre un schéma-bloc d'un exemple de réalisation d'une sous-table de division incorporée dans la table dynamique de la figure 1 ;
La figure 3B illustre une simplification de câblage de la structure de la figure 3A ; et

La figure 4 illustre un schéma-bloc d'un opérateur de calcul de CRC étendu à plusieurs chiffres d'un message, exploitant la structure de la figure 1 de multiples fois.

**Description détaillée de l'invention**

Dans la présente demande, pour calculer un code CRC sur un message, on propose d'utiliser une table de valeurs de CRC qui est dynamiquement reconfigurable en fonction d'un polynôme réducteur, et cela en un cycle d'une horloge de transmission des données, ou du moins en un nombre de cycles réduit compatible avec une opération en mode pipeline. Pour cela, la table, bien que se comportant de l'extérieur comme une table statique stockant des valeurs fixes, a une structure interne dynamique en logique combinatoire qui génère les valeurs de la table en réponse au polynôme réducteur P fourni comme seul paramètre à la table.

Pour atteindre une reconfiguration suffisamment rapide en réponse à un changement du polynôme réducteur, la table comprend deux sous-tables dynamiques dont les valeurs sont générées en réponse au polynôme réducteur appliqué en paramètre. Les deux sous-tables sont configurées de sorte que les valeurs de l'une opèrent une sélection des valeurs de l'autre.

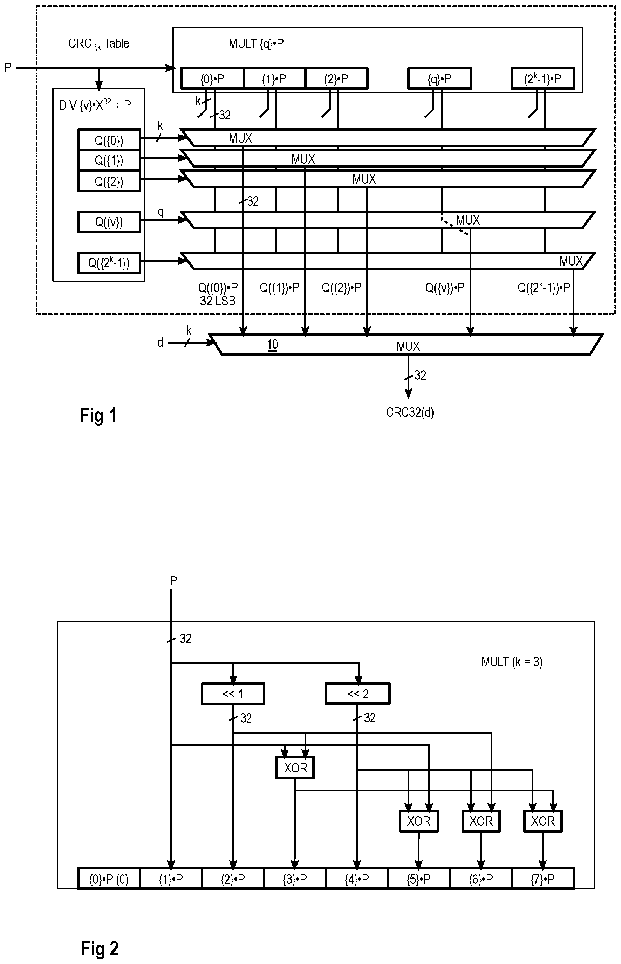

La figure 1 illustre cette structure plus en détail, dans le cadre du calcul d'un code CRC de 32 bits pour un chiffre d de k bits. La table dynamique est notée $CRC_{P,k}$, où P est le polynôme réducteur, ici de degré N = 32, et k le nombre de bits du chiffre d dont on calcule le code.

Une première sous-table, de multiplication MULT, contient les multiples {q}•P du polynôme P par tous les éléments {q} définissables sur k bits, soit les éléments de GF($2^k$). Les multiples sont rangés dans la table dans l'ordre des valeurs scalaires q des éléments {q}.

Ainsi, la table MULT est illustrée comme contenant dans l'ordre les produits {0}•P, {1}•P, {2}•P... {q}•P... {$2^k$-1}•P.

Chaque produit étant le résultat de la multiplication d'un polynôme de degré 32 par un polynôme de degré k-1, le produit est un polynôme de degré k + 31, à savoir un nombre de k + 32 bits. Pour les besoins du calcul d'un code de 32 bits, il s'avère qu'on n'a besoin de stocker que les 32 bits de poids faible des produits, puisque le code est pris sur le reste d'une division, où seuls les bits de poids faible importent. Ainsi, comme cela est illustré par des lignes déconnectées, les k bits de poids fort des produits sont ignorés (et ne sont d'ailleurs pas stockés). Il en résulte aussi que le terme de degré 32 du polynôme P, qui correspond à un bit de rang 33 toujours à 1, est aussi omis.

Une deuxième sous-table, de division DIV, contient les quotients Q issus des divisions euclidiennes des polynômes {v}•$X^{32}$ par le polynôme P, où {v} parcourt tous les éléments de GF($2^k$). (Un élément {v}•$X^{32}$, en binaire, n'est autre que la valeur binaire {v} décalée à gauche de 32 bits, soit une valeur binaire de k + 32 bits dont les 32 bits de poids faible sont tous nuls.) Les quotients sont notés Q({0}), Q({1})... Q({v})... Q({$2^k$-1}), et ils sont rangés dans l'ordre des valeurs scalaires v des éléments {v}. Les quotients sont des valeurs binaires codées sur k bits.

Chaque cellule Q({v}) de la table de division DIV est associée à une sortie de rang v de la table globale $CRC_{P,k}$. La valeur scalaire q du contenu d'une cellule Q({v}) est utilisée pour sélectionner la cellule de rang q de la table de multiplication MULT, et transmettre le contenu {q}•P de cette cellule sur la sortie de rang v de la table globale (comme cela est illustré par des pointillés entre la rangée v et la colonne q). Ainsi, une sortie de rang v fournit le produit {q}•P = Q({v})•P, dont les 32 bits de poids faible, d'après les propriétés des CRC, s'avèrent aussi être le reste de la division, à savoir le code CRC cherché de {v}.

Selon le mode de réalisation représenté, pour réaliser cette fonctionnalité d'aiguillage, le contenu q d'une cellule Q({v}) sert d'index à un multiplexeur respectif dont la sortie forme la sortie de rang v de la table globale. Le multiplexeur reçoit les contenus des cellules de la table MULT sur ses entrées respectives, dans l'ordre des rangs des cellules de la table MULT.

Pour produire le code CRC d'un chiffre donné d de k bits, on prévoit un multiplexeur 10 qui prend le chiffre d comme index et qui reçoit sur ses entrées respectives les sorties de la table globale, dans l'ordre des rangs de ces sorties.

La table $CRC_{P,k}$ est de structure relativement complexe si on devait n'utiliser qu'un seul polynôme réducteur P. En effet, dans ce cas, il suffirait de seulement stocker les valeurs Q({0})•P à Q({$2^k$-1})•P. La complexité additionnelle trouve tout son sens lorsque le polynôme P est variable de façon arbitraire, car ce choix particulier de partitionnement en sous-tables permet une mise à jour au vol de ces sous-tables lors d'une modification du polynôme, à l'aide de moyens matériels relativement peu complexes et rapides, tels qu'exposés ci-après.

La figure 2 représente un schéma plus détaillé d'un exemple optimisé de table de multiplication MULT configurable dynamiquement par le polynôme P, pour k = 3. Pour construire une telle table en logique combinatoire de manière triviale, on pourrait produire chaque sortie {i}•P en additionnant P à la sortie précédente {i-1}•P, l'addition étant une opération ou-exclusif bit-à-bit. Toutefois, cela mettrait en cascade jusqu'à $2^k$-1 portes ou-exclusif entre la première sortie et la dernière sortie, formant un chemin critique conséquent dans le circuit en logique combinatoire correspondant.

La règle récursive suivante permet de réduire significativement le chemin critique de la logique combinatoire. Il est rappelé que, pour les besoins du calcul de codes CRC, les valeurs en binaire sont tronquées aux 32 bits de poids faible et omettent le terme en $X^{32}$ du polynôme P.

$$\{0\} \bullet P = \{0\}$$

Pour i variant de 0 à k-1 :

$$\{2^i\} \bullet P = P \ll i$$

à savoir que les bits de la représentation binaire du polynôme P sont décalés à gauche de i positions, en remplissant de zéros les i bits créés à droite et en éliminant les i bits débordant à gauche.

Pour j variant de $(2^i + 1)$ à $(2^{i+1} - 1)$ :

$$\{j\} \bullet P = \{2^i\} \bullet P \; xor \; \{j - 2^i\} \bullet P,$$

où « xor » désigne une opération ou-exclusif bit-à-bit, soit l'opération d'addition dans le corps de Galois.

La décomposition $j = (2^i) + (j-2^i)$ permet dans cette étape d'itération de réutiliser deux termes précédemment calculés relativement proches en rang, cela de sorte à mettre le moins possible de portes ou-exclusif en cascade.

Le schéma de la figure 2 est une transcription directe en éléments de circuit numérique de cette règle récursive pour k = 3, selon laquelle on obtient la décomposition suivante :

$$\{0\} \bullet P = \{0\}$$

$$\{1\} \bullet P = P \ll 0 = P$$

$$\{2\} \bullet P = P \ll 1$$

$$\{3\} \bullet P = \{2\} \bullet P \; xor \; \{1\} \bullet P$$

$$\{4\} \bullet P = P \ll 2$$

$$\{5\} \bullet P = \{4\} \bullet P \; xor \; \{1\} \bullet P$$

$$\{6\} \bullet P = \{4\} \bullet P \; xor \; \{2\} \bullet P$$

$$\{7\} \bullet P = \{4\} \bullet P \; xor \; \{3\} \bullet P$$

Les éléments de décalage à gauche $\ll 1$ et $\ll 2$ sont réalisés par simple câblage croisé, et n'introduisent aucun retard. On s'aperçoit que le chemin critique comporte au plus deux portes ou-exclusif XOR, celle de la sortie $\{3\} \bullet P$ suivie de celle de la sortie $\{7\} \bullet P$, au lieu de 6 portes pour une structure triviale entre la sortie $\{1\} \bullet P$ et la sortie $\{7\} \bullet P$.

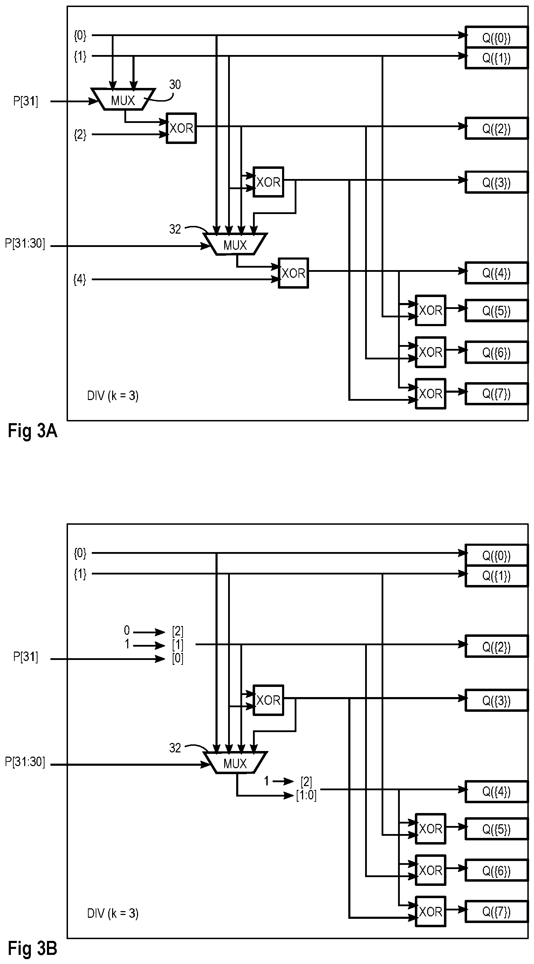

La figure 3A représente un schéma plus détaillé d'un exemple optimisé de table de division DIV configurable dynamiquement par le polynôme P, pour k = 3. La règle de construction itérative utilisée est la suivante. On ne considère que les termes de degré inférieur ou égal à 31 du polynôme P, à savoir 32 bits.

$$Q(\{0\}) = \{0\}$$

Pour i variant de 0 à k-1 :

$$Q(\{2^i\}) = \{2^i\} \; xor \; Q(P >> 32\text{-}i),$$

où P >> 32-i, à savoir le décalage à droite de 32-i positions de la représentation binaire du polynôme P (sans le terme $X^{32}$), est une notation concise pour exprimer qu'on ne garde que les i bits de poids fort de P.

Pour j variant de $(2^i + 1)$ à $(2^{i+1} - 1)$ :

$$Q(\{j\}) = Q(\{2^i\}) \; xor \; Q(\{j - 2^i\}).$$

Le schéma de la figure 3A est une transcription directe en éléments de circuit numérique de cette règle récursive pour k = 3, selon laquelle on obtient la décomposition suivante, où les quotients sont codés sur k = 3 bits :

$$Q(\{0\}) = \{0\}$$

$$Q(\{1\}) = \{1\} \; xor \; Q(P >> 32) = \{1\} \; xor \; Q(\{0\}) = \{1\}$$

$$Q(\{2\}) = \{2\} \; xor \; Q(P >> 31) = \{2\} \; xor \; Q(P[31])$$

$$Q(\{3\}) = Q(\{2\}) \; xor \; Q(\{1\})$$

$$Q(\{4\}) = \{4\} \; xor \; Q(P >> 30) = \{4\} \; xor \; Q(P[31:30])$$

$$Q(\{5\}) = Q(\{4\}) \; xor \; Q(\{1\})$$

$$Q(\{6\}) = Q(\{4\}) \; xor \; Q(\{2\})$$

$$Q(\{7\}) = Q(\{4\}) \; xor \; Q(\{3\})$$

Les termes $Q(P[31])$ et $Q(P[31:30])$, contrairement aux autres termes des calculs, ne sont pas localisables dans la table indépendamment du polynôme P - ils dépendent en effet des bits individuels du polynôme appliqué à la table. Ainsi, le quotients $Q(\{2\})$ et $Q(\{4\})$ qui en dépendent respectivement comportent dans leur chemin de génération un multiplexeur MUX qui sélectionne le quotient à utiliser en fonction du polynôme P appliqué.

Plus spécifiquement, pour fournir le terme $Q(P[31])$ intervenant dans la génération du quotient $Q(\{2\})$, un multiplexeur 30 indexé par le bit P[31] reçoit sur ses entrées, dans l'ordre, les constantes {0} et {1} qui sont aussi les sorties $Q(\{0\})$ et $Q(\{1\})$ de la table. En fait, ce multiplexeur pourrait être omis en fournissant pour $Q(P[31])$ directement le bit P[31] comme bit de poids faible d'un nombre de k = 3 bits.

Pour fournir le terme $Q(P[31:30])$ intervenant dans la génération du quotient $Q(\{4\})$, un multiplexeur 32 indexé par les bits P[31:30] reçoit sur ses entrées, dans l'ordre, les sorties $Q(\{0\})$ à $Q(\{3\})$ de la table.

Pour une valeur plus grande de k, les premiers éléments illustrés sont inchangés. Le quotient suivant $Q(\{8\})$ à générer s'exprime par :

$$Q(\{8\}) = \{8\} \; xor \; Q(P[31:29]).$$

Le terme $Q(P[31:29])$ est matérialisé par un multiplexeur indexé par les trois bits P[31:29] et recevant sur ses entrées respectivement les quotients $Q(\{0\})$ à $Q(\{7\})$, en fait tous les quotients qui précèdent $Q(\{8\})$.

Les quotients suivants $Q(\{9\})$ à $Q(\{15\})$ sont relativement simples à générer, chacun étant une combinaison par ou-exclusif de deux quotients précédents localisables statiquement dans la table selon la deuxième étape de la règle itérative.

Le quotient suivant Q({16}) fait intervenir le terme Q(P[31:28]) qui est matérialisé par un multiplexeur indexé par les quatre bits P[31:28] et qui reçoit sur ses entrées respectivement les quotients Q({0}) à Q({15}). Et ainsi de suite.

Compte tenu que les portes XOR associées aux sorties des multiplexeurs ont une entrée recevant une valeur ({2}, {4}) dont un seul bit fixe est à 1 et une entrée recevant une valeur dont des bits de poids plus faible sont significatifs, ces portes ne sont pas nécessaires en pratique. En fait, leur fonction peut être obtenue par simple juxtaposition des fils véhiculant les bits des deux entrées de la porte XOR.

La figure 3B illustre une structure simplifiée résultant de cette propriété. Le quotient Q({2}) est formé des bits 0, 1 et P[31], par ordre de poids décroissants, tandis que le quotient Q({4}) est formé du bit 1 et des deux bits de sortie du multiplexeur associé à ce quotient.

Compte tenu de la structure de la table de CRC de la figure 1, sa taille augmente quadratiquement avec $2^k$. On peut donc souhaiter obtenir un compromis entre la complexité de l'opérateur et la rapidité de calcul, cela en exploitant des propriétés du calcul des CRC.

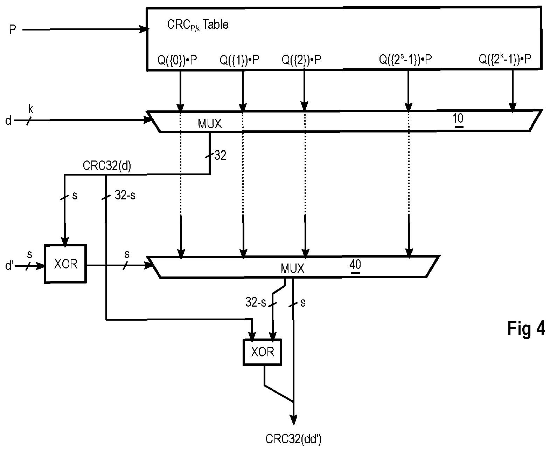

La figure 4 illustre une application d'une table $CRC_{P,k}$ adaptée initialement à un chiffre de k bits (comme celle de la figure 1) pour calculer le code CRC sur un chiffre étendu dd' de k + s bits. On suppose que le chiffre étendu dd' est composé d'un chiffre de poids fort d de k bits et d'un chiffre de poids faible d' de s bits. Dans l'exemple on suppose que s est inférieur ou égal à k.

Ce circuit utilise la propriété selon laquelle un code CRC peut être calculé de façon récursive sur des chiffres consécutifs d'un message pour former le code du message complet. Le circuit de la figure 4 est conçu pour effectuer deux itérations simultanément en logique combinatoire.

Plus spécifiquement, la relation récursive utilisée est la suivante, en sachant que les décalages opèrent dans une fenêtre de 32 bits, donc que les bits sortant de la fenêtre sont supprimés et les bits entrant dans la fenêtre sont mis à 0.

$$\mathrm{CRC(dd')} = (\mathrm{CRC(d)} \ll s) \; xor \; \mathrm{CRC(d'} \; xor \; (\mathrm{CRC(d)} \gg (32\text{-}s))$$

On retrouve intégralement la structure de la figure 1, à savoir la table $CRC_{P,k}$ et le multiplexeur 10, pour générer un code intermédiaire CRC32(d) du chiffre d.

Le chiffre d'et les s bits de poids fort du code CRC32(d) sont combinés par une porte XOR qui commande un multiplexeur 40. Le multiplexeur 40 est connecté en parallèle avec le multiplexeur 10 sur les $2^s$ premières sorties de la table $CRC_{P,k}$.

Les 32-s bits de poids faible du code CRC32(d) et les 32-s bits de poids fort de la sortie du multiplexeur 40 sont combinés par une porte XOR pour former les 32-s bits de poids fort du code CRC du chiffre étendu dd'. Les s bits de poids faible de ce code sont formés par les s bits de poids faible de la sortie du multiplexeur 40.

On peut ainsi utiliser une seule table de CRC pour calculer le code CRC sur un chiffre jusqu'à deux fois plus grand (avec s = k), avec peu d'augmentation de complexité.

**Revendications**

1. Circuit de génération d'un code de redondance cyclique de N bits sur un chiffre d de k bits, le code étant basé sur un polynôme réducteur reconfigurable P de degré N, le circuit incluant une table dynamique comprenant :

   une sous-table de multiplication dynamique connectée pour recevoir le polynôme P sous forme binaire et produisant sur des sorties respectives les produits résultant de la multiplication par le polynôme P de chaque élément définissable sur k bits, dans l'ordre des valeurs scalaires des éléments de k bits ;
   une sous-table de division dynamique connectée pour recevoir le polynôme P sous forme binaire et produisant sur des sorties respectives les quotients résultant de la division euclidienne par le polynôme P de chaque élément définissable sur k bits décalé de N bits vers la gauche, dans l'ordre des valeurs scalaires des éléments de k bits ; et
   un groupe de premiers multiplexeurs, chaque multiplexeur étant connecté pour être indexé par une sortie respective de la table de division pour transmettre la sortie correspondante de la table de multiplication sur une sortie de la table dynamique de même rang que la sortie respective de la table de division.

2. Circuit selon la revendication 1, comprenant en outre :
   un deuxième multiplexeur (10) indexé par le chiffre d pour transmettre la sortie de rang correspondant de la table dynamique comme code du chiffre d.

3. Circuit selon la revendication 1, dans lequel la sous-table de division est configurée pour :

pour i variant de 1 à k-1 :
générer la sortie de rang 2' comme une opération ou-exclusif bit-à-bit entre le nombre binaire $\{2^i\}$ et une sortie de rang précédent défini par i bits de poids fort du polynôme réducteur ; et
pour j variant de $(2' + 1)$ à $(2^{i+1} - 1)$ :
générer la sortie de rang j par une opération ou-exclusif bit-à-bit entre les sorties de rangs 2' et j - 2'.

4. Circuit selon la revendication 3, dans lequel la sous-table de division comprend :

pour chaque sortie de rang 2' de la sous-table de division, où i varie de 1 à k-1 :

un multiplexeur indexé par i bits de poids fort du polynôme réducteur (P) et recevant sur ses entrées respectivement les sorties de rangs 0 à 2'-1 de la sous-table de division ;
une porte ou-exclusif bit-à-bit produisant la sortie de rang 2' de la sous-table de division à partir du nombre binaire $\{2'\}$ et la sortie du multiplexeur associé au rang 2' ; et

pour chaque sortie de rang j, où j varie de $(2' + 1)$ à $(2^{i+1} - 1)$ :
une porte ou-exclusif bit-à-bit recevant les sorties de rangs 2' et j - 2' de la sous-table de division.

5. Circuit selon la revendication 4, dans lequel la porte ou-exclusif associée à un rang 2' est formée par un câblage produisant la sortie de rang 2' de sorte que le bit de poids i soit fixé à 1 et les bits de poids inférieur à i correspondent à la sortie du multiplexeur associé au rang 2'.

6. Circuit selon la revendication 1, dans lequel la sous-table de multiplication est configurée pour :

pour i variant de 1 à k-1 :
générer la sortie de rang 2' par un décalage à gauche de i positions du polynôme réducteur ; et
pour j variant de $(2' + 1)$ à $(2^{i+1} - 1)$ :
générer la sortie de rang j par une opération ou-exclusif bit-à-bit entre les sorties de rangs 2' et j - 2'.

7. Circuit selon la revendication 2 pour générer un code CRC sur une donnée formée d'un chiffre d de k bits de poids fort et d'un chiffre d' de s bits de poids faible, comprenant en outre :

un troisième multiplexeur (40) indexé par un deuxième chiffre de s bits pour transmettre la sortie de rang correspondant de la table dynamique ;
une première porte ou-exclusif bit-à-bit formant le deuxième chiffre de s bits à partir du chiffre d'et les s bits de poids fort du code du chiffre d fourni par le deuxième multiplexeur (10) ;
une deuxième porte ou-exclusif bit-à-bit recevant les N-s bits de poids faible du code du chiffre d et les N-s bits de poids fort de la sortie du troisième multiplexeur, le code de la donnée étant formé des N-s bits de poids fort la sortie de la deuxième porte ou-exclusif et des s bits de poids faible de la sortie du troisième multiplexeur.

**Patentansprüche**

1. Schaltung zum Generieren eines zyklischen N-Bit-Redundanzcodes auf einer k-Bit-Ziffer d, wobei der Code auf einem rekonfigurierbaren reduzierenden Polynom P des Grades N basiert, wobei die Schaltung eine dynamische Tabelle enthält, umfassend:

eine dynamische Multiplikationssubtabelle, die so verbunden ist, dass sie das Polynom P in binärer Form empfängt und an jeweiligen Ausgängen die Produkte, die sich aus der Multiplikation jedes definierbaren k-Bit-Elements mit dem Polynom P ergeben, in der Reihenfolge der Skalarwerte der k-Bit-Elemente erzeugt;
eine dynamische Divisionssubtabelle, die so verbunden ist, dass sie das Polynom P in binärer Form empfängt und an jeweiligen Ausgängen die Quotienten, die sich aus der euklidischen Division jedes definierbaren k-Bit-Elements, das um N Bits nach links verschoben ist, durch das Polynom P ergeben, in der Reihenfolge der Skalarwerte der k-Bit-Elemente erzeugt; und
eine Gruppe von ersten Multiplexern, wobei jeder Multiplexer so verbunden ist, dass er durch einen jeweiligen Ausgang der Divisionstabelle indiziert wird, um den entsprechenden Ausgang der Multiplikationstabelle auf einen Ausgang der dynamischen Tabelle zu übertragen, der den gleichen Rang wie der jeweilige Ausgang der Divisionstabelle aufweist.

**2.** Schaltung nach Anspruch 1, ferner umfassend:
einen zweiten Multiplexer (10), der durch die Ziffer d indiziert ist, um den Ausgang des der dynamischen Tabelle entsprechenden Rangs als Code der Ziffer d zu übertragen.

**3.** Schaltung nach Anspruch 1, wobei die Divisionssubtabelle konfiguriert ist zum:

für i, das von 1 bis k-1 variiert:
Generieren des Ausgangs des Rangs 2' als eine bitweise Exklusiv-ODER-Operation zwischen der Binärzahl {2'} und einem Ausgang des vorherigen Rangs, der durch i höchstwertige Bits des reduzierenden Polynoms definiert ist; und
für j, das von $(2' + 1)$ bis $(2^{i+1} - 1)$ variiert:
Generieren des Ausgangs des Rangs j durch eine bitweise Exklusiv-ODER-Operation zwischen den Ausgängen der Ränge 2' und j - 2'.

**4.** Schaltung nach Anspruch 3, wobei die Divisionssubtabelle umfasst:

für jeden Ausgang des Rangs 2' der Divisionssubtabelle, wobei i von 1 bis k-1 variiert:

einen Multiplexer, der durch i höchstwertige Bits des reduzierenden Polynoms (P) indiziert ist und an seinen Eingängen jeweils die Ausgänge der Ränge 0 bis $2^i$-1 der Divisionssubtabelle empfängt;
ein bitweises Exklusiv-ODER-Gatter, das den Ausgang des Rangs 2' der Divisionssubtabelle aus der Binärzahl $\{2^i\}$ und den Ausgang des dem Rang 2' zugeordneten Multiplexers erzeugt; und

für jeden Ausgang des Rangs j, wobei j von $(2' + 1)$ bis $(2^{i+1} - 1)$ variiert:
ein bitweises Exklusiv-ODER-Gatter, das die Ausgänge der Ränge 2' und j - 2' der Divisionssubtabelle empfängt.

**5.** Schaltung nach Anspruch 4, wobei das einem Rang $2^i$ zugeordnete Exklusiv-ODER-Gatter durch eine Verdrahtung gebildet wird, die den Ausgang des Rangs 2' so erzeugt, dass das Bit mit der Wertigkeit i auf 1 gesetzt ist und die Bits mit einer Wertigkeit kleiner als i dem Ausgang des dem Rang 2' zugeordneten Multiplexers entsprechen.

**6.** Schaltung nach Anspruch 1, wobei die Multiplikationssubtabelle konfiguriert zum:

für i, das von 1 bis k-1 variiert:
Generieren des Ausgangs des Rangs 2' durch eine Linksverschiebung um i Stellen des reduzierenden Polynoms; und
für j, das von $(2' + 1)$ bis $(2^{i+1} - 1)$ variiert:
Generieren des Ausgangs des Rangs j durch eine bitweise Exklusiv-ODER-Operation zwischen den Ausgängen der Ränge 2' und j - 2'.

**7.** Schaltung nach Anspruch 2 zum Generieren eines CRC-Codes an einem Datenwert, der aus einer Ziffer d mit k höherwertigen Bits und einer Ziffer d' mit s niederwertigen Bits gebildet wird, ferner umfassend:

einen dritten Multiplexer (40), der durch eine zweite Ziffer von s Bits indiziert ist, um den Ausgang des der dynamischen Tabelle entsprechenden Rangs zu übertragen;
ein erstes bitweises Exklusiv-ODER-Gatter, das die zweite Ziffer von s Bits aus der Ziffer d' und den s höchstwertigen Bits des vom zweiten Multiplexer (10) gelieferten Codes der Ziffer d bildet;
ein zweites bitweises Exklusiv-ODER-Gatter, das die N-s niederwertigen Bits des Codes der Ziffer d und die N-s höchstwertigen Bits des Ausgangs des dritten Multiplexers empfängt, wobei der Code des Datenwerts aus den N-s höchstwertigen Bits des Ausgangs des zweiten Exklusiv-ODER-Gatters und den s niederwertigen Bits des Ausgangs des dritten Multiplexers gebildet wird.

**Claims**

**1.** A circuit for generating an N-bit cyclic redundancy code (CRC) of a k-bit digit d, the code being based on a reconfigurable generator polynomial P of degree N, the circuit including a dynamic table comprising:

a dynamic multiplication sub-table (MULT) connected to receive the polynomial P in binary form and providing, on respective outputs, products resulting from the multiplication by the polynomial P of each element definable over k bits, ordered by the scalar values of the k-bit elements;

a dynamic division sub-table (DIV) connected to receive the polynomial P in binary form and providing, on respective outputs, quotients resulting from the Euclidean division by the polynomial P of each k-bit element shifted by N bits to the left, ordered by the scalar values of the k-bit elements; and

a group of first multiplexers (MUX), each multiplexer being connected to be indexed by a respective output of the division table to transmit the contents of a corresponding output of the multiplication table to an output of the dynamic table, of same rank (v) as the respective output of the division table.

2. The circuit of claim 1, further comprising:
a second multiplexer (10) indexed by the digit d to transmit the output of corresponding rank of the dynamic table as the code of the digit d.

3. The circuit of claim 1, wherein the division sub-table (DIV) is configured to:

for i varying from 1 to k-1:
generate the output of rank 2' as a bit-to-bit exclusive-OR operation between the binary number {2i} and an output of previous rank defined by i most significant bits of the generator polynomial; and
for j varying from (2' + 1) to ($2^{i+1}$ - 1):
generate the output of rank j by a bit-to-bit exclusive-OR operation between the outputs of ranks 2' and j - 2'.

4. The circuit of claim 3, wherein the division sub-table (DIV) comprises:

for each output of rank 2' of the division sub-table, where i varies from 0 to k-1:

a multiplexer (MUX) indexed by i most significant bits of the generator polynomial (P) and receiving on its inputs respectively the outputs of ranks 0 to $2^i$-1 of the division sub-table;
a bit-to-bit exclusive-OR gate producing the output of rank 2' of the division sub-table from the binary number {$2^i$} and the output of the multiplexer associated with rank 2'; and

for each output of rank j, where j varies from (2' + 1) to ($2^{i+1}$ - 1):
a bit-to-bit exclusive-OR gate receiving the outputs of ranks 2' and j - 2' of the division sub-table.

5. The circuit of claim 4, wherein the exclusive-OR gate associated with a rank 2' includes wiring producing the output of rank 2' such that the bit of weight i is set to 1 and the bits of weight less than i correspond to the output of the multiplexer associated with rank 2'.

6. The circuit of claim 1, wherein the multiplication sub-table (MULT) is configured to:

for i varying from 0 to k-1:
generate the output of rank 2' by shifting the generator polynomial by i positions to the left; and
for j varying from (2' + 1) to ($2^{i+1}$ - 1):
generate the output of rank j by a bit-to-bit exclusive-OR operation between the outputs of ranks 2' and j - $2^i$.

7. The circuit of claim 2 for generating a CRC code on a data item formed by a digit d of k most significant bits and a digit d' of s least significant bits, further comprising:

a third multiplexer (40) indexed by a second s-bit digit to transmit the output of corresponding rank of the dynamic table;
a first bit-to-bit exclusive-OR gate forming the second s-bit digit from the digit d' and the s most significant bits of the code of the digit d provided by the second multiplexer (10); and
a second bit-to-bit exclusive-OR gate receiving the N-s least significant bits of the code of the digit d and the N-s most significant bits of the output of the third multiplexer, the code of the data item being formed by the N-s most significant bits of the output of the second exclusive-OR gate and the s least significant bits of the output of the third multiplexer.

**Fig 1**

**Fig 2**

Fig 3A

Fig 3B

P

CRC$_{P,k}$ Table

Q({0})•P    Q({1})•P    Q({2})•P    Q({2$^s$-1})•P    Q({2$^k$-1})•P

d    k

MUX    $\underline{10}$

CRC32(d)

32

s    32-s

d'    s    XOR    s

MUX    $\underline{40}$

32-s    s

XOR

CRC32(dd')

Fig 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6223320 B
- US 200915778 A1, Gopal Vinodh
- US 2006282743 A1, Kouvanis Michael

**Littérature non-brevet citée dans la description**

- **DAVID FELDMEIER.** Fast software implementation of error détection codes. *IEEE/ACM Transactions on Networking, NY, US,* Décembre 1995, vol. 3 (6), 640-651